# EUROPEAN PATENT APPLICATION

(11) **EP 2 168 916 A1**
(43) Date of publication of application: **31.03.2010**
(21) Application number: 08777888.2
(22) Date of filing: 04.07.2008
(51) Int. Cl.: C01B 33/02

(54) **SINTERED SILICON WAFER**

(30) Priority: 13.07.2007 JP 2007184757; 21.03.2008 JP 2008073586
(71) Applicant: Nippon Mining & Metals Co., Ltd., Tokyo 105-0001 (JP)
(72) Inventor: SUZUKI, Ryo, Kitaibaraki-shi Ibaraki 319-1535 (JP); TAKAMURA, Hiroshi, Kitaibaraki-shi Ibaraki 319-1535 (JP)
(74) Representative: Hoarton, Lloyd Douglas Charles
(86) International application number: PCT/JP2008/062173
(87) International publication number: WO 2009/011234

(57) **Abstract**

Provided is a sintered silicon wafer, wherein the ratio [I(220)/I(111)...(1)] of intensity of a (220) plane and intensity of a (111) plane measured by X-ray diffraction is 0.5 or more and 0.8 or less, and the ratio [I(311)/I(111)...(2)] of intensity of a (311) plane and intensity of a (111) plane is 0.3 or more and 0.5 or less. The provided sintered silicon wafer has a smooth surface in which its surface roughness is equivalent to a single crystal silicon.

## Description

### TECHNICAL FIELD

The present invention relates to a sintered silicon wafer having a smooth surface.

### BACKGROUND ART

A wafer that is produced based on the single crystal pulling method is exclusively used in the silicon semiconductor production process. This single crystal silicon wafer has been enlarged over time, and it is anticipated that the size will be 400mm or larger in the near future. And in order to establish devices and peripheral technology that are required in the semiconductor production process, a so-called mechanical wafer is required for testing purposes.
Generally speaking, since this kind of mechanical wafer is used in testing that requires considerably high precision, it is required to possess characteristics that are similar to the mechanical physicality of a single crystal silicon. Thus, conventionally, a single crystal silicon wafer was used as is even for testing purposes, in reality. However, since a single crystal silicon wafer that is 400mm or larger costs much, an inexpensive wafer having similar characteristics as a single crystal silicon is in demand.

When using a polycrystalline silicon wafer as a mechanical wafer, the biggest challenge is for a polycrystalline silicon sintered compact to have the same level of smoothness as a single crystal silicon wafer. With conventional technology, it has been thought difficult for a polycrystalline silicon wafer to have the same level of smoothness as a single crystal silicon wafer.

Aiming to improve the characteristics of a silicon sintered compact, proposed is a silicon sintered compact obtained by compression-molding and sintering silicon powder that was heated and deoxidized under reduced pressure within a temperature range of 1200°C or higher and less than the melting point of silicon, wherein the grain size of the sintered compact is set to be 100µm or less (for instance, refer to Patent Literature 1). Nevertheless, the polycrystalline silicon sintered compact produced as described above has never been given attention to the smoothness of the surface.

The Applicant previously proposed a sintered compact target and its production method in which the average grain size is 50µm or less, and the relative density is 99% or higher (refer to Patent Literature 2). Although this silicon sintered compact yields numerous advantages such as high density and high mechanical strength, improvement in the smoothness of the silicon sintered compact surface is still demanded.
[Patent Literature]
[PTL 1] Japanese Patent No.3342898
[PTL 2] Japanese Patent No.3819863

### DISCLOSURE OF INVENTION

The present invention was devised in view of the foregoing points. Thus, an object of this invention is to provide a sintered silicon wafer having a smooth surface of which roughness is equivalent to a single crystal silicon.

To achieve the foregoing object, the present inventors discovered that a sintered silicon wafer having a smooth surface that is equivalent to the smoothness of a single crystal silicon can be obtained by devising the sintering conditions and adjusting the crystal orientation.
Based on the foregoing discovery, the present invention provides:
1. A sintered silicon wafer, wherein the ratio [I(220)/I(111)...(1)] of intensity of a (220) plane and intensity of a (111) plane measured by X-ray diffraction is 0.5 or more and 0.8 or less, and the ratio [I(311)/I(111)...(2)] of intensity of a (311) plane and intensity of a (111) plane is 0.3 or more and 0.5 or less; and
2. The sintered silicon wafer according to paragraph 1 above, wherein the ratio of intensity of a plane other than the (220) plane and the (311) plane and intensity of the (111) plane measured by X-ray diffraction is 0.2 or less.

The present invention additionally provides:
3. The sintered silicon wafer according to paragraph 1 or paragraph 2 above, wherein, with the plane orientation intensity ratio (1) regarding the (220) plane and the plane orientation intensity ratio (2) regarding the (311) plane measured in the sintered silicon wafer plane, |(1) - (1)'| is 0.1 or less and |(2) - (2)'| is 0.05 or less in relation to their respective intensity ratios (1)' and (2)' measured in a plane that is perpendicular to the wafer plane; and
4. The sintered silicon wafer according to any one of paragraphs 1 to 3 above having a surface roughness Ra of 0.02µm or less.

Thus, it is possible to provide a sintered silicon wafer having a smooth surface which has an extremely similar surface roughness as that of a single crystal silicon used as a mechanical wafer.

### BEST MODE FOR CARRYING OUT THE INVENTION

The present invention provides sintered silicon wafer, wherein the ratio [I(220)/I(111)...(1)] of intensity of a (220) plane and intensity of a (111) plane measured by X-ray diffraction is 0.5 or more and 0.8 or less, and the ratio [I(311)/I(111)...(2)] of intensity of a (311) plane and intensity of a (111) plane is 0.3 or more and 0.5 or less.
Accordingly, it is possible to provide a sintered silicon wafer having a smooth surface in which the surface roughness is equivalent to a single crystal silicon. This is a result of adjusting the crystal orientation of the sintered silicon wafer, and deviating a sintered silicon wafer from the foregoing crystal orientation is unable to have a surface roughness that is equivalent to a single crystal silicon.

The sintered silicon wafer of the present invention comprising the foregoing crystal orientation aims to achieve a surface roughness that is equivalent to a single crystal silicon, and not to seek the improvement of mechanical properties. With that said, however, it is also possible to seek the improvement of mechanical properties simultaneously with seeking the smoothness of the sintered silicon wafer. In the present invention, it should be understood that the adjustment of the foregoing crystal orientation and the improvement of the mechanical intensity are not incompatible.

With the sintered silicon wafer of the present invention, the ratio of intensity of a plane other than the (220) plane and the (311) plane and intensity of the (111) plane measured by X-ray diffraction is 0.2 or less. The plane orientations other than the (220) plane and the (311) plane to be measured by X-ray diffraction include (331) and (400), but these plane orientations should be kept to a minimum since they impair the smoothness.
Moreover, desirably, with the plane orientation intensity ratio (1) regarding the (220) plane and the plane orientation intensity ratio (2) regarding the (311) plane measured in the sintered silicon wafer plane, |(1) - (1)'| is 0.1 or less and |(2) - (2)'| is 0.05 or less in relation to their respective intensity ratios (1)' and (2)' measured in a plane that is perpendicular to the wafer plane. In other words, it could be said that the uniformity of the plane orientation in the silicon wafer will lead to the sintered silicon wafer comprising characteristics that are common with a single crystal silicon wafer. The sintered silicon wafer prepared as described above has a surface roughness Ra of 0.02µm or less. The present invention covers all of the foregoing aspects.

Effective ways of improving the mechanical properties are refinement of the grain size, and elimination of oxides, carbides and metal silicides contained in the sintered silicon wafer. Consequently, it is possible to easily achieve transverse rupture intensity based on the three-point flexural shear test method in an average value of 20kgf/mm² to 50kgf/mm², tensile intensity in an average value of 5kgf/mm² to 20kgf/mm², and Vickers hardness in an average value of Hv800 to Hv1200. As described above, the foregoing act of seeking the improvement of the mechanical properties is not incompatible with the adjustment of the crystal orientation.

As a method of producing a silicon sintered compact, for instance, the steps of pulverizing coarse grains of high purity silicon having a purity of 5N or higher with a jet mill, baking and deoxidizing the obtained silicon powder under reduced pressure within a temperature range of 1100 to 1300°C, preferably less than 1200°C, performing primary sintering thereto by way of hot pressing, and thereafter performing HIP processing within a heating temperature of 1200 to 1420°C and at atmospheric pressure of 1000 atm or higher may be adopted.

In the foregoing case, the crystal orientation can be adjusted by using high purity silicon powder and pulverizing such powder, adopting the foregoing deoxidation conditions based on baking, and adopting the foregoing HIP treatment temperature, holding time and pressurization conditions. Specifically, it is possible to obtain a sintered silicon wafer, wherein the ratio [I(220)/I(111)...(1)] of intensity of a (220) plane and intensity of a (111) plane measured by X-ray diffraction is 0.5 or more and 0.8 or less, and the ratio [I(311)/I(111)...(2)] of intensity of a (311) plane and intensity of a (111) plane is 0.3 or more and 0.5 or less.

In addition, based on a similar process, the mechanical intensity of the sintered silicon wafer can be simultaneously improved by adjusting the sintering conditions so that the maximum grain size will be 20µm or less, and the average grain size will be 1µm or more and 10µm or less. Moreover, in order to improve the mechanical intensity in the foregoing process, deoxidation is a useful process. Besides deoxidation is effective in obtaining a silicon sintered compact of fine crystals efficiently. Deoxidation is performed by setting the baking temperature to be 1000 to 1300°C, and preferably less than 1200°C.

The production conditions of the foregoing silicon sintered compact enables to achieve transverse rupture intensity easily based on the three-point flexural shear test method in an average value of 20kgf/mm² to 50kgf/mm², tensile intensity in an average value of 5kgf/mm² to 20kgf/mm², and Vickers hardness in an average value of Hv800 to Hv1200. These mechanical properties are equivalent to those of amorphous silicon. The following Examples and Comparative Examples are within the scope of the foregoing production conditions, and their mechanical properties satisfied the mechanical properties of amorphous silicon in all cases.

### [Examples]

The present invention is now explained in detail with reference to the Examples. These Examples are merely illustrative, and the present invention shall in no way be limited thereby. In other words, various modifications and other embodiments based on the technical spirit claimed in the present invention shall be included as a matter of course.

### (Example 1)

Silicon powder having an average grain size of 5µm obtained by pulverizing coarse silicon grains having a purity of 6N with a jet mill was baked and deoxidized for 5 hours under reduced pressure upon raising the temperature to 1000°C.
Subsequently, the temperature was raised to 1200°C and hot pressing was simultaneously performed by setting the bearing to 200kgf/cm², and this was thereafter subject to HIP treatment at a temperature of 1300°C, welding pressure of 1800 atm, and holding time of 3 hours so as to obtain a silicon sintered compact having a diameter of 400mm.
The crystal orientation can be arbitrarily adjusted by selecting each condition such as use of high purity silicon, baking (deoxidation) condition, the hot press temperature and welding pressure, the HIP temperature and welding pressure, and holding time. The product was further ground to obtain a silicon wafer.

With respect to the silicon sintered compact wafer of Example 1, the intensity of the crystal plane was measured by X-ray diffraction. Consequently, the ratio [I(220)/I(111)] of intensity of the (220) plane and intensity of the (111) plane was 0.6, and the ratio [I(311)/I(111)] of intensity of the (311) plane and intensity of the (111) plane was 0.4. The surface roughness Ra in the foregoing case was 0.01, which is equivalent to a single crystal silicon wafer.

**Table 1 (Examples)**

| | I (220)/I (111) | I (310)/I (111) | Surface Roughness Ra (µm) |
|---|---|---|---|
| Example 1 | 0.6 | 0.4 | 0.01 |
| Example 2 | 0.5 | 0.5 | 0.01 |
| Example 3 | 0.5 | 0.3 | 0.02 |
| Example 4 | 0.5 | 0.4 | 0.01 |
| Example 5 | 0.8 | 0.3 | 0.02 |
| Example 6 | 0.8 | 0.5 | 0.02 |
| Example 7 | 0.7 | 0.4 | 0.01 |

| | | | |
|---|---|---|---|
| I(220)/I (111) means ratio of intensity of (220) plane/ (111) plane I(310)/I (111) means ratio of intensity of (310) plane / (111) plane | | | |

### (Examples 2 to 7)

As with Example 1, silicon powders respectively having a purity of 5N and 6N were baked and deoxidized under reduced pressure within a temperature range of 1100 to 1300°C, and further hot pressed within a temperature range of 1200 to 1420°C at a bearing of 200kgf/cm² or greater. The silicon obtained thereby was further subject to HIP treatment within a temperature range of 1200 to 1420°C and at atmospheric pressure of 1000 atm or higher, and various silicon sintered compact wafers as shown in Table 1 were produced.

The intensity of the crystal plane of the foregoing silicon sintered compact wafers was measured by X-ray diffraction. The results are similarly shown in Table1. As shown in Table 1, the ratio [I(220)/I(111)] of intensity of the (220) plane and intensity of the (111) plane was 0.5 to 0.8, and the ratio [I(311)/I(111)] of intensity of the (311) plane and intensity of the (111) plane was 0.3 to 0.5. The surface roughness Ra in the foregoing cases was 0.01 to 0.02, which is equivalent to that of a single crystal silicon wafer.

### (Examples 8 to 10)

Next, based on Example 1, which is a typical example of the present invention, comparative experiments were conducted for cases where the ratio of intensity of planes other than the (220) plane and the (311) plane and intensity of the (111) plane measured by X-ray diffraction is 0.2 or less. The results are shown in Table 2. As shown in Table 2, the existence of planes other than the (220) plane and the (311) plane had a tendency of increasing the surface roughness. When the intensity ratio of Example 8 was 0.2, the surface roughness Ra was barely 0.02µm or less. Thus, more preferably, it could be said that the ratio of intensity of a plane other than the (220) plane and the (311) plane and intensity of the (111) plane measured by X-ray diffraction is 0.2 or less.

With a single crystal silicon wafer, it could be said that there is basically no difference in the characteristics between a wafer plane and a surface that is perpendicular to the wafer plane. Therefore, with a sintered silicon wafer, it is desirable that the difference in the plane orientation intensity ratio (1) regarding the (220) plane and the plane orientation intensity ratio (2) regarding the (311) plane that are similarly measured, and the respective intensity ratios (1)' and (2)' that are measured in a plane that is perpendicular to the wafer plane; that is, |(1) - (1)'| is 0.1 or less and |(2) - (2)'| is as low as possible. In this respect, the tolerable range was set to 0.05 or less, which has been confirmed in all Examples 1 to 10 within the foregoing range, though not shown in the Tables.

**Table 2 (Examples)**

| | I (XYZ)/I (111) | Surface Roughness Ra (µm) |
|---|---|---|
| Example 8 | 0.2 | 0.02 |
| Example 9 | 0.1 | 0.01 |
| Example 10 | 0.05 | <0.01 |

| | | |
|---|---|---|
| I (XYZ)/I (111) means ratio of intensity of a plane other than (220) plane and (310)plane and intensity of (111) plane | | |

### (Comparative Examples 1 to 5)

The sintered silicon wafers shown in Table 3 were prepared by using silicon having a purity of 6N and respectively selecting conditions such as baking (deoxidation), the HIP temperature, holding time, and welding pressure, and thereafter the intensity of the crystal plane of these silicon sintered compact wafers was measured by X-ray diffraction. Consequently, the ratio [I(220)/I(111)] of intensity of the (220) plane and intensity of the (111) plane was 0.4 or less and 0.9 or more, and the ratio [I(311)/I(111)] of intensity of the (311) plane and intensity of the (111) plane was 0.3 or less and 0.6 or more. The surface roughness Ra was 0.04 to 0.08µm, which is coarsened.

The silicon sintered compact wafers of the Comparative Examples did not have a surface roughness Ra of 0.02µm or less, which is required in a mechanical wafer, and did not satisfy the characteristics required as a mechanical wafer. The deterioration of these characteristics is considered to be caused by these silicon sintered compact wafers not satisfying the conditions of the present invention; specifically, the ratio [I(220)/I(111)...(1)] of intensity of a (220) plane and intensity of a (111) plane measured by X-ray diffraction is 0.5 or more and 0.8 or less, and the ratio [I(311)/I(111)...(2)] of intensity of a (311) plane and intensity of a (111) plane is 0.3 or more and 0.5 or less.

**Table 3 (Comparative Examples)**

| | I (220)I (111) | I(310)/I (111) | Surface Roughness Ra (µm) |
|---|---|---|---|
| Comparative Example 1 | 0.4 | 0.2 | 0.05 |
| Comparative Example 2 | 0.3 | 0.2 | 0.08 |
| Comparative Example 3 | 0.9 | 0.2 | 0.04 |
| Comparative Example 4 | 0.4 | 0.6 | 0.05 |
| Comparative Example 5 | 0.3 | 0.3 | 0.04 |

| | | | |
|---|---|---|---|
| I(220)I] (111) means ratio of intensity of (220) plane and (111) plane I(310)/I (111) means ratio of intensity of (310) plane and (111) plane | | | |

### INDUSTRIALAPPLICABILITY

The present invention is able to provide a sintered silicon wafer having a smooth surface, and yields a significant advantage in being able to provide a sintered silicon wafer having an extremely similar surface roughness as that of a single crystal silicon that is used as a mechanical wafer. Thus, the present invention provides a useful mechanical wafer.

## Claims

1. . A sintered silicon wafer, wherein the ratio [I(220)/I(111)...(1)] of intensity of a (220) plane and intensity of a (111) plane measured by X-ray diffraction is 0.5 or more and 0.8 or less, and the ratio [I(311)/I(111)...(2)] of intensity of a (311) plane and intensity of a (111) plane is 0.3 or more and 0.5 or less.

2. . The sintered silicon wafer according to claim 1, wherein the ratio of intensity of a plane other than the (220) plane and the (311) plane and intensity of the (111) plane measured by X-ray diffraction is 0.2 or less.

3. . The sintered silicon wafer according to claim 1 or claim 2, wherein, with the plane orientation intensity ratio (1) regarding the (220) plane and the plane orientation intensity ratio (2) regarding the (311) plane measured in the sintered silicon wafer plane, |(1) - (1)'| is 0.1 or less and |(2) - (2)'| is 0.05 or less in relation to their respective intensity ratios (1)' and (2)' measured in a plane that is perpendicular to the wafer plane.

4. . The sintered silicon wafer according to any one of claims 1 to 3 having a surface roughness Ra of 0.02µm or less.
